(19) Europäisches Patentamt
European Patent Office
Office européen des brevets

(11) **EP 1 847 839 B1**

(12) **FASCICULE DE BREVET EUROPEEN**

(45) Date de publication et mention
de la délivrance du brevet:
**04.04.2012  Bulletin 2012/14**

(51) Int Cl.:
*G01R 31/02* (2006.01)    *G01R 31/34* (2006.01)

(21) Numéro de dépôt: **07290451.9**

(22) Date de dépôt: **12.04.2007**

(54) **Procédé de dépistage d'un court-circuit résistif, système, module et support d'enregistrement pour ce procédé**

Verfahren zur Erkennung eines Widerstandskurzschlusses, System, Modul und Aufzeichnungsdatenträger für dieses Verfahren

Method of screening a resistive short-circuit, system, module and recording medium for this method

(84) Etats contractants désignés:
**AT BE BG CH CY CZ DE DK EE ES FI FR GB GR HU IE IS IT LI LT LU LV MC MT NL PL PT RO SE SI SK TR**

(30) Priorité: **21.04.2006  FR 0603560**

(43) Date de publication de la demande:
**24.10.2007  Bulletin 2007/43**

(73) Titulaire: **ALSTOM Transport SA**
**92300 Levallois-Perret (FR)**

(72) Inventeurs:
• **Belin, Sébastien**
**65800 Aureilhan (FR)**

• **Cypers, David**
**65310 Odos (FR)**
• **Giacomoni, Olivier**
**65290 Juillan (FR)**

(74) Mandataire: **Blot, Philippe Robert Emile et al**
**Cabinet Lavoix**
**2, place d'Estienne d'Orves**
**75441 Paris Cedex 09 (FR)**

(56) Documents cités:
**WO-A-01/06272    JP-A- 8 029 470**
**JP-A- 9 009 660    JP-A- 2001 245 401**
**US-A- 6 049 185**

## Description

La présente invention concerne un procédé de dépistage d'un court-circuit impédant ayant une partie réelle non nulle, un système, un module et un support d'enregistrement pour ce procédé.

Il existe des systèmes de traction pour véhicules ayant :

- un moteur polyphasé à aimants permanents ou un moteur polyphasé synchrone bobiné, ce moteur ayant pour chaque phase un ou plusieurs bobinages d'excitation propre à générer un champ magnétique d'entraînement en rotation d'un arbre du moteur,
- des conducteurs de phase pour raccorder les bobinages de chaque phase du moteur à une source d'alimentation polyphasée commandable,
- des capteurs de courant associés aux conducteurs de phase, ces capteurs étant propres à mesurer le courant circulant dans chaque conducteur de phase, et
- un module de commande propre à commander le couple de l'arbre du moteur en fonction des courants mesurés par les capteurs.

Certains de ces systèmes de traction sont également équipés d'au moins une charge résistive raccordable entre chaque paire de conducteurs de phase par l'intermédiaire d'au moins un interrupteur commandable.

La charge résistive est souvent utilisée pour dissiper l'énergie de freinage du véhicule ou pour atténuer des surtensions.

Un court-circuit impédant est un court-circuit qui s'établit entre deux enroulements du moteur normalement isolés électriquement l'un de l'autre. Toutefois ce court-circuit présente une certaine impédance. Typiquement la partie réelle, c'est-à-dire la partie résistive, de cette impédance est supérieure à quelques milliohms et généralement supérieure à 10 mΩ. Pour simplifier, dans la suite de cette description un court-circuit impédant dont la partie réelle est non nulle, sera appelé « court-circuit résistif ». La partie imaginaire d'un tel court-circuit peut être nulle ou pas.

Par exemple, un tel court circuit résistif peut se produire lorsque des enroulements d'un même bobinage du moteur sont court-circuités les uns avec les autres ou lorsque des enroulements de deux bobinages différents sont court-circuités les uns avec les autres.

Aujourd'hui, en cas de dysfonctionnement du moteur à cause du court-circuit, il est connu de :

1) connecter électriquement les extrémités de tous les conducteurs de phases à un point commun, soit
2) de déconnecter électriquement les conducteurs de phases du moteur.

La solution 1) permet d'équilibrer les courants dans chacune des phases du moteur et ceci malgré l'existence du court-circuit résistif. Cela annule ou réduit fortement le courant traversant le court-circuit résistif. L'intensité du courant est donc strictement la même dans chacun des conducteurs de phases. Aucune information sur l'existence d'un court-circuit résistif ne peut être obtenue à partir de mesures de ce courant équilibré.

Si la solution 2) est utilisée, aucun courant ne circule dans les conducteurs de phases de sorte que les capteurs de courant ne peuvent pas être utilisés pour détecter l'existence d'un court-circuit résistif.

Dès lors, les systèmes existants comportent aussi souvent au moins un capteur spécifique dédié à la détection d'un défaut du moteur tel qu'un court-circuit entre des enroulements du moteur.

Les capteurs spécifiques pour détecter un court-circuit résistif ne sont pas toujours fiables. Dans ce contexte, il est souhaitable de détecter un court-circuit résistif sans avoir recours aux capteurs spécifiques.

Le document WO 01/06272 A (GEN ELECTRIC [US]), 25 janvier 2001, décrit un procédé et appareil de détection des courts-circuits dans un système polyphasé avec moteur, ou des capteurs de courant capteurs sont associés aux conducteurs de phase.

Le document US-A-6 049 185 (IKEDA HIDEO [JP]), 11 avril 2000, décrit également un circuit de détection des courts-circuits dans un système polyphasé avec moteur.

L'invention vise à satisfaire ce souhait en proposant un procédé de dépistage d'un court-circuit résistif ne nécessitant pas la mise en oeuvre d'un capteur spécifiquement dédié à cet usage.

L'invention a donc pour objet un procédé de dépistage d'un court-circuit résistif dans le système de traction ci-dessus comprenant les étapes consistant à:

a) commander le système de traction pour faire fonctionner le moteur en générateur de courant polyphasé,
b) commander le ou les interrupteurs commandables pour raccorder la charge résistive entre chaque paire de conducteurs de phase, cette charge résistive étant apte à permettre la détection d'un court-circuit électrique résistif au moins par comparaison des puissances des fondamentaux des courants mesurés par chacun des capteurs, et
c) détecter l'existence du court-circuit électrique résistif à partir des courants mesurés par les capteurs lorsque la charge résistive est raccordée entre chaque paire de conducteurs de phase et que le moteur fonctionne en générateur de courant.

Dans le procédé ci-dessus, les mêmes capteurs de courant que ceux utilisés pour commander le couple du moteur sont utilisés afin de détecter l'existence d'un court-circuit résistif. Ce procédé est donc plus simple à mettre en oeuvre puisqu'il ne nécessite pas le recours à des capteurs spécifiques dédiés à la détection de court-circuits résistifs.

Les modes de réalisation de ce procédé de dépistage peuvent comporter une ou plusieurs des caractéristiques suivantes :

- une étape d) de détection d'une défaillance du système de traction sans qu'il soit nécessaire pour cela de faire fonctionner le moteur comme un générateur de courant, et dans lequel les étapes a) à c) sont déclenchées uniquement en réponse à la détection d'une défaillance lors de l'étape d) ;
- la valeur de la partie résistive de la charge résistive est variable et le procédé comporte une étape d'ajustement de la valeur de cette partie résistive jusqu'à ce que la détection du court-circuit électrique résistif soit au moins possible par comparaison des puissances des fondamentaux des courants mesurés par chacun des capteurs ;
- la charge résistive raccordée entre chaque paire de conducteurs de phase lors de l'étape b), est la même que celle raccordée entre les conducteurs de phase pour dissiper l'énergie générée par le moteur lors d'un freinage de l'arbre du moteur ;
- la source d'alimentation polyphasée comprend un onduleur/redresseur raccordé électriquement d'un côté aux conducteurs de phase et de l'autre à une paire de conducteurs de tension continue, et l'étape b) consiste à commander le raccordement de la charge résistive entre les conducteurs de tension continue ;
- la résistance du ou des bobinages d'une même phase du moteur est appelée résistance interne et notée $R_{int}$, et, lors de l'étape b), la valeur de la partie résistive de la charge raccordée entre chaque paire de conducteurs de phase est comprise entre $R_{int}$ et $20000.R_{int}$ de manière à ce qu'une partie du courant généré par le moteur traverse le court-circuit résistif tandis qu'une autre partie du courant généré par le moteur circule dans les conducteurs de phase.

Ces modes de réalisation du procédé de dépistage présentent en outre les avantages suivants :

- utiliser une étape de détection d'une défaillance du système de traction avant d'exécuter les étapes a) à c) permet de limiter le nombre de fois où ces étapes sont exécutées et donc de limiter le freinage du véhicule,
- ajuster la valeur de la partie résistive permet d'adapter le procédé au court-circuit à dépister afin de conserver un bon niveau de sensibilité quelle que soit l'impédance de ce court-circuit résistif,
- utiliser la même charge résistive que celle utilisée pour dissiper l'énergie lors du freinage du véhicule permet également de simplifier l'implémentation du procédé de détermination, et
- utiliser une charge résistive raccordable entre les conducteurs de tension continue permet de simplifier l'implémentation du procédé car il est alors possible de n'utiliser qu'un seul interrupteur pour raccorder la charge résistive entre chaque paire de conducteurs de phase.

L'invention a également pour objet un support d'enregistrement d'informations comportant des instructions pour l'exécution du procédé de dépistage ci-dessus lorsque ces instructions sont exécutées par un calculateur électronique.

L'invention a également pour objet un système de traction d'un véhicule comportant :

- un moteur polyphasé à aimants permanents ou un moteur polyphasé synchrone bobiné, ce moteur ayant pour chaque phase un ou plusieurs bobinages d'excitation propre à générer un champ magnétique d'entraînement en rotation d'un arbre du moteur,
- des conducteurs de phase pour raccorder les bobinages de chaque phase du moteur à une source d'alimentation polyphasée commandable,
- des capteurs de courant associés aux conducteurs de phase, ces capteurs étant propres à mesurer le courant circulant dans chaque conducteur de phase,
- un module de commande propre à commander le couple de l'arbre du moteur en fonction des courants mesurés par les capteurs,
- au moins une charge résistive raccordable entre chaque paire de conducteurs de phase par l'intermédiaire d'au moins un interrupteur commandable, et
- un module de diagnostic apte à mettre en oeuvre un procédé de dépistage d'un court-circuit électrique résistif.

Enfin, l'invention a également pour objet un module de diagnostic apte à être mis en oeuvre dans le système de traction ci-dessus, dans lequel le module de diagnostic est apte à mettre en oeuvre le procédé ci-dessus de dépistage d'un court-circuit résistif.

L'invention sera mieux comprise à la lecture de la description qui va suivre, donnée uniquement à titre d'exemple non limitatif et faite en se référant aux dessins sur lesquels :

- la figure 1 est une illustration d'un véhicule équipé d'un système de traction électrique,
- la figure 2 est un organigramme d'un procédé de dépistage d'un court-circuit résistif dans le système de traction de la figure 1, et
- la figure 3 est une illustration schématique de l'architecture d'un autre mode de réalisation d'un système de traction dans lequel le procédé de la figure 2 est exécuté.

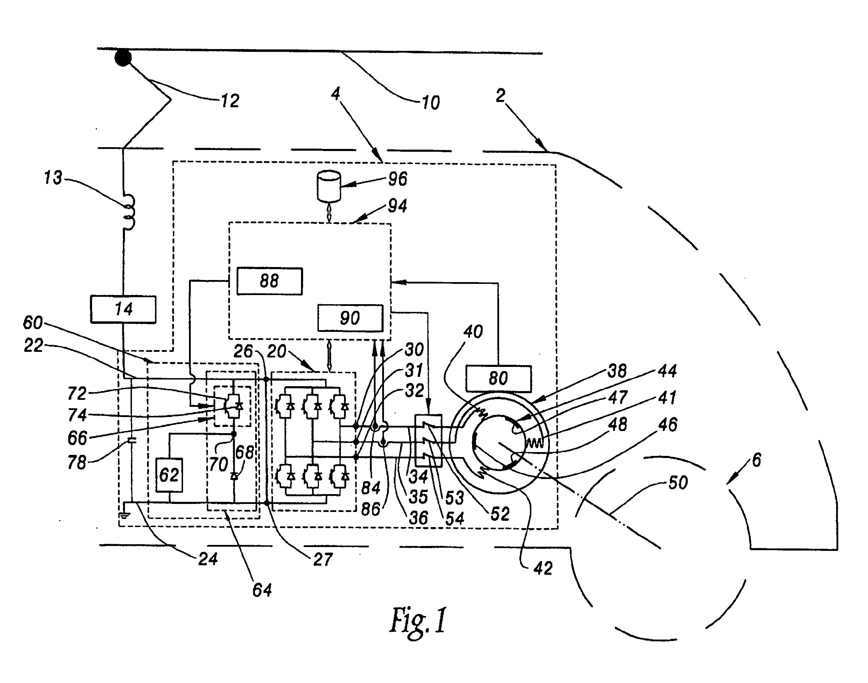

La figure 1 représente un véhicule 2 équipé d'un système de traction 4 propre à entraîner en rotation des roues motrices du véhicule 2. Ici, le véhicule 2 est un véhicule ferroviaire tel qu'un train.

Dans la suite de cette description, les caractéristiques et fonctions bien connues de l'homme du métier ne sont pas décrites en détail.

De plus, pour simplifier la figure 1, seule une roue motrice 6 a été représentée.

Le système 4 est alimenté en tension continue à partir d'une caténaire 10. Plus précisément, le système 4 est raccordé à la caténaire 10 par l'intermédiaire d'un pantographe 12 et d'une self d'entrée 13 connecté en série avec un disjoncteur 14.

Le système 4 comprend une source d'alimentation triphasée formée d'un bus d'alimentation en tension continue raccordé à l'entrée d'un onduleur/redresseur triphasé commandable 20.

Le bus d'alimentation est ici formé de deux conducteurs électriques 22 et 24. Le conducteur 22 est électriquement raccordé à une sortie du disjoncteur 14 délivrant la tension d'alimentation. Le conducteur électrique 24 est raccordé à un potentiel de référence tel que la masse.

Ces conducteurs 22 et 24 sont électriquement raccordés par l'une de leurs extrémités à des entrées 26 et 27 de tension continue de l'onduleur/redresseur 20.

L'onduleur/redresseur 20 comprend trois sorties 30, 31 et 32 de tension alternative raccordées, respectivement, à des conducteurs de phase 34 à 36.

Cet onduleur/redresseur 20 est apte à transformer la tension continue présente entre les conducteurs 22 et 24 en une tension alternative délivrée sur les sorties 30 à 32 et vice versa.

L'onduleur/redresseur 20 est un onduleur/redresseur conventionnel équipé d'interrupteurs commandables tels que des transistors IGBT (Insulated Gate Bipolar Transistor).

Classiquement, cet onduleur/redresseur 20 comporte trois branches raccordées en parallèle, chaque branche comprend deux interrupteurs commandables raccordés en série aux bornes desquelles sont raccordées des diodes de roue libre en position antiparallèle.

Chaque conducteur 34 à 36 alimente des bobinages statoriques d'une phase respective d'un moteur triphasé 38 à aimants permanents.

A titre d'illustration, seuls trois bobinages statoriques 40 à 42 alimentés respectivement par les conducteurs 34 à 36 sont représentés sur la figure 1. Ces bobinages statoriques sont aptes à produire un champ magnétique d'excitation propre à entraîner en rotation un rotor 44 équipé d'aimants permanents. Pour simplifier la figure 1, seuls trois aimants permanents 46 à 48 sont représentés.

On rappelle que la résistance interne du moteur 38 est définie comme étant la résistance de l'ensemble des bobinages d'une phase. Dans le cas d'un moteur monté en étoile, cette résistance peut être mesurée en mesurant la résistance du moteur prise entre deux bornes de connexion des conducteurs de phase et en divisant la résistance mesurée par deux, de manière à obtenir la résistance des bobinages d'une seule phase. Typiquement, la valeur $R_{int}$ de la résistance interne d'un moteur polyphasé est comprise entre 5 mΩ et 100 mΩ. Par exemple, la valeur $R_{int}$ de la résistance interne du moteur 38 est égale à 40 mΩ.

Le rotor 44 entraîne en rotation un arbre 50 qui lui-même entraîne en rotation, par l'intermédiaire de mécanismes non représentés, les roues motrices du véhicule 2.

Les contacteurs commandables 52 à 54 permettent de déconnecter électriquement les conducteurs de phase 34 à 36, des bobinages du moteur 38.

Une charge résistive variable 60 est raccordable en entrée de l'onduleur/redresseur 20 entre les conducteurs 22 et 24. On notera que raccorder une charge résistive entre les conducteurs 22 et 24 revient, d'un point de vue électrique, à raccorder une charge résistive entre chaque paire de conducteurs de phase 34 à 36.

La charge 60 est conçue de manière à ce que la valeur de sa partie résistive raccordée entre chaque paire de conducteurs de phase soit comprise entre $R_{int}$ et $200000.R_{int}$, où le symbole « . » désigne la multiplication. De préférence, la charge 60 est conçue de manière à ce que la valeur de sa partie résistive raccordée entre chaque paire de conducteurs de phase puisse varier entre $R_{int}$ et $20000.R_{int}$ voir même de $R_{int}$ à $2000.R_{int}$. Dans le cas particulier décrit, la partie résistive raccordée entre chaque paire de conducteurs de phase peut varier entre 40 mΩ et 8 Ω. Ainsi, pour la plupart des court-circuits résistifs pouvant apparaître il est possible d'ajuster la valeur de la partie résistive de la charge 60 pour qu'une partie du courant circule dans les conducteurs de phase tandis qu'une autre partie du courant traverse le court-circuit résistif.

Ici, cette charge 60 est également destinée à dissiper l'énergie de freinage lorsque le moteur 38 fonctionne en générateur de courant pour freiner le véhicule 2.

La charge 60 comprend une résistance 62 de valeur constante $R_H$ et un hacheur rhéostatique 64. $R_H$ est ici égal à $\frac{2}{3} \cdot R_{int}$. La résistance 62 est directement raccordée par l'une de ses extrémités au conducteur 24 et par l'autre de ses extrémités au conducteur 22 par l'intermédiaire du hacheur 64. Le hacheur 64 permet, lorsqu'il est activé, de connecter la charge 60 au conducteur 22 et lorsqu'il est désactivé, d'isoler électriquement la charge 60 du conducteur 22. De plus, lorsque le hacheur est activé, celui-ci permet de faire varier la valeur de la partie résistive de la charge 60 en hachant le courant traversant la résistance 62.

Ce hacheur 64 comprend ici un interrupteur commandable 66 raccordé en série avec une diode 68 par l'intermédiaire d'un point commun 70.

L'interrupteur 68 est ici réalisé à l'aide d'un transistor IGBT 72 dont le collecteur est directement raccordé au conducteur 22 et l'émetteur au point 70. Une diode de roue libre 74 est raccordée en position antiparallèle aux bornes du transistor 72.

La cathode de la diode 68 est raccordée au point 70 tandis que son anode est directement raccordée au conducteur 24.

Le point milieu 70 est raccordé à la résistance 62.

Lorsque le hacheur 64 est activé, la fréquence de commutation $f_c$ de l'interrupteur 66 est comprise entre 50 Hz et 10 kHz. Par exemple, ici la fréquence $f_c$ est égale à 400 Hz. Le taux d'ouverture $T_X$ de l'interrupteur 66 est commandable. Ici, le taux d'ouverture $T_X$ peut varier entre 0.005 et 1.

On définit ici le taux d'ouverture $T_X$ de ce hacheur 64 à l'aide de la relation suivante :

$$T_X = t_{on} \cdot f_c \qquad\qquad (1)$$

où :

- $T_X$ est le taux d'ouverture,
- $t_{on}$ est l'intervalle de temps pendant lequel l'interrupteur 66 est passant sur chaque période $1/f_c$, et
- $f_c$ est la fréquence de commutation.

La valeur $R_{eq}$ de la charge résistive 60 lorsque le hacheur 64 est activé est donnée par la relation suivante :

$$R_{eq} = \frac{R_H}{T_X} \qquad\qquad (2)$$

où :

- $R_{eq}$ est la valeur de la partie résistive de la charge 60,
- $R_H$ est la valeur de la résistance 62, et
- $T_X$ est le taux d'ouverture.

Une capacité de filtrage 78 est raccordée en permanence entre les conducteurs 22 et 24.

Le système 4 comprend un capteur 80 dédié uniquement à la détection d'une défaillance du moteur 38. Le capteur 80 est apte à mesurer des caractéristiques représentatives du fonctionnement du moteur 38. Ces caractéristiques permettent de détecter une défaillance du moteur même lorsque celui-ci entraîne en rotation les roues motrices. Le capteur 80 est, par exemple, un détecteur de vibrations du moteur 38.

Le système 4 est aussi équipé de capteurs de courant propres à mesurer le courant dans chacun des conducteurs de phase 34 à 36. A cet effet, ici, seuls deux capteurs de courant 84 et 86 associés respectivement aux conducteurs 34 et 35 sont utilisés. En effet, la valeur du courant dans le conducteur 36 peut être déduite à partir des mesures réalisées par les capteurs 84 et 86.

Un module de commande 88 est apte à partir des mesures de courant réalisées par les capteurs 84 et 86 à commander le couple de l'arbre 50 du moteur 38. Plus précisément, à cet effet, le module de commande 88 commande l'onduleur/redresseur 20.

Le module 88 est également apte à commander les contacteurs 52 à 54 ainsi que le hacheur 64.

Enfin, le système 4 comprend un module 90 de diagnostic propre à détecter une défaillance du moteur 38 à partir des mesures du capteur 80 et également à détecter un court-circuit résistif entre des enroulements et bobinages de ce moteur à partir des mesures de courant réalisées par les capteurs 84 et 86. A cet effet, le module 90 est apte à commander l'onduleur/redresseur 20 et le hacheur 64.

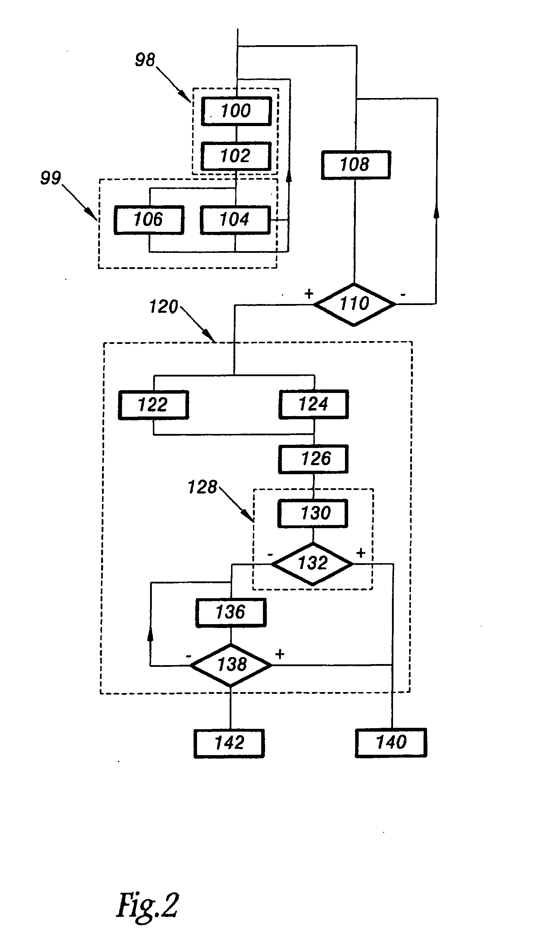

Les modules 88 et 90 sont, par exemple, réalisés à l'aide d'un calculateur électronique programmable 94 propre à exécuter les instructions enregistrées dans une mémoire 96. A cet effet, la mémoire 96 comporte des instructions pour l'exécution du procédé de la figure 2 lorsque celles-ci sont exécutées par le calculateur 94.

Le fonctionnement du système 4 va maintenant être décrit en regard du procédé de la figure 2.

Initialement, le système 4 ne présente aucune défaillance. Dans ces conditions, des phases 98 de propulsion du véhicule 2 sont alternées avec des phases 99 de freinage du véhicule.

Lors de la phase 98 de propulsion, les capteurs 84 et 86 mesurent, lors d'une étape 100, le courant dans les conducteurs de phase 34 et 35 et transmettent ces mesures au module de commande 88. Ensuite, lors d'une étape 102, le module 88 commande l'onduleur/redresseur 20 de manière à ajuster le couple de traction exercé par le moteur 38 en fonction des courants mesurés et d'une consigne de couple.

Lors de la phase 99 de freinage du véhicule, le module 88 commande, lors d'une étape 104, l'onduleur/ redresseur 20 pour que celui-ci fonctionne comme un redresseur de tensions et que le moteur 38 fonctionne comme un générateur de courant triphasé. En parallèle de l'étape 104, lors d'une étape 106, le module 88 commande le hacheur 64 pour ajuster la valeur de la partie résistive de la charge 60, de manière à ce que celle-ci dissipe l'énergie générée par le moteur 38 lors du freinage du véhicule 2.

En parallèle des phases 98 et 99, lors d'une étape 108, le capteur 80 mesure en permanence des caractéristiques du moteur 38 à partir desquelles une défaillance de ce moteur peut être détectée. Ces mesures sont analysées en temps réel, lors d'une étape 110, par le module 90 de diagnostic. Si à partir de ces mesures, le module 90 ne détecte pas une défaillance du moteur 38, alors aucune action particulière n'est entreprise et les phases 98 et 99 continuent de s'exécuter normalement. Dans ce cas, à l'issue de l'étape 110, le procédé retourne à l'étape 108.

Dans le cas contraire, c'est-à-dire si lors de l'étape 110, le module 90 détecte qu'il existe une défaillance du moteur 38, alors les phases 98 et 89 sont interrompues et le procédé se poursuit par une phase 120 de dépistage d'un court-circuit résistif entre des enroulements de bobinages du moteur 38.

Au début de la phase 120, lors d'une étape 122, le module 90 commande l'onduleur/redresseur 20 pour faire fonctionner le moteur 38 en générateur de courant triphasé et l'onduleur/redresseur comme un redresseur de courant triphasé. Plus précisément, lors de l'étape 122, le module 90 maintient ouvert les transistors IGBT de l'onduleur/redresseur 20 de manière à ce que celui-ci se comporte comme un pont redresseur à diodes.

En parallèle, lors d'une étape 124, le module 90 commande l'activation du hacheur 64 pour raccorder la charge 60 entre les conducteurs 22 et 24. Lors de l'étape 124, par exemple, le taux d'ouverture $T_X$ du hacheur 64 passe directement de la valeur 0 à la valeur 1 de manière à ce que la valeur de la partie résistive de la charge 60 soit minimale.

Ainsi, à l'issue des étapes 122 et 124, le moteur 38 freine le véhicule 2. De plus, pratiquement la totalité du courant généré par le moteur 38 traverse les conducteurs de phase car la valeur de la charge 60 raccordée entre les conducteurs 22 et 24 est sensiblement égale à $R_{int}$. Dans ces conditions, l'aggravement de la défaillance du moteur est limité.

Ensuite, lors d'une étape 126, les capteurs 84 et 86 mesurent le courant qui circule dans les conducteurs de phase 34 et 35 et transmettent ces mesures au module 90.

A partir de ces mesures, lors d'une étape 128, le module 90 essaye de détecter l'existence d'un court-circuit résistif. Plus précisément, lors de l'étape 128, le module 90, détermine, lors d'une opération 130, la puissance des fondamentaux de tous les courants de phase à partir des mesures réalisées par les capteurs 84 et 86. Ici, ces fondamentaux ont une fréquence égale à la fréquence statorique du moteur 38. Ensuite, lors d'une opération 132, les puissances ainsi déterminées sont comparées deux par deux.

Si les puissances de ces fondamentaux de courant sont sensiblement égales, alors, lors d'une étape 136, le module 90 commande le hacheur 64 pour accroître la valeur de la partie résistive de la charge 60 d'un pas prédéterminé. Par exemple, lors de l'étape 130, le module 90 diminue le taux d'ouverture $T_X$ du hacheur rhéostatique 64 d'un pas prédéterminé. Ce pas prédéterminé est, par exemple, égal à 0.05.

Ensuite, il procède à une étape 138, lors de laquelle le module 90 essaye à nouveau de détecter l'existence d'un court-circuit résistif. Cette étape 138 est, par exemple, identique à l'étape 128. Dans la négative, le procédé retourne à l'étape 136. Ainsi, le module 90 accroît progressivement la valeur de la partie résistive de la charge 60 jusqu'à ce que celle-ci soit suffisante pour qu'une partie substantielle du courant généré par le moteur 38 circule dans les conducteurs de phase tandis qu'une autre partie substantielle du courant traverse le court-circuit résistif. La partie du courant est dite « substantielle » dès lors qu'elle permet la détection d'un court-circuit à partir des courants mesurés par les capteurs 84 et 86 en appliquant une méthode de détection telle que celle décrite en regard de l'étape 128. Ici, dans le cas où il existe réellement un court-circuit entre des enroulements des bobinages du moteur 38, la différence entre les puissances des fondamentaux de courant dépasse, par exemple, un seuil prédéterminé, ce qui permet d'établir l'existence du court-circuit résistif. De plus, en fonction des amplitudes des fondamentaux qui diffèrent l'une de l'autre, il est possible de déterminer quelle est la phase ou les phases du moteur 38 touchées par le court-circuit résistif.

Si lors de l'étape 128, ou lors de l'étape 138, il est établi qu'il existe un court-circuit résistif, alors la phase 120 s'achève et se poursuit par une étape 140 lors de laquelle le conducteur du véhicule 2 est informé de l'existence d'un court-circuit résistif.

Si la valeur de la partie résistive de la charge 60 atteint sa valeur maximale sans qu'aucun court-circuit résistif n'ait pu être détecté lors de l'étape 128 ou lors des étapes 138, alors le procédé s'arrête, lors d'une étape 142, et l'existence d'un court-circuit résistif n'est pas confirmée.

On notera ici que dans ce mode de réalisation particulier, étant donné que les capteurs 84 et 86 sont placés en amont des contacteurs 52 à 54, le module 90 permet également de détecter un court-circuit entre ces contacteurs 52 à 54 et un court-circuit résistif entre les conducteurs de phase reliant ces conducteurs 52 à 54 à des bornes de connexion du moteur 38.

De plus, de préférence, ici le module 90 est également apte à détecter une défaillance de l'onduleur/redresseur 20 étant donné que le courant mesuré par les capteurs 84 et 86 traverse également l'onduleur/redresseur 20 avant d'atteindre la charge 60.

Enfin, on comprend que lorsqu'une partie substantielle du courant traverse le court-circuit résistif et que l'autre partie substantielle du courant généré par le moteur 38 circule dans les conducteurs de phase, le courant dans les conducteurs de phase est fonction du court-circuit résistif établi. Dès lors, à partir des mesures de ces courants de phase, il est possible non seulement de déterminer l'existence d'un court-circuit résistif mais également de préciser quelle est la ou quelles sont les phases du moteur 38 concerné par ce court-circuit résistif.

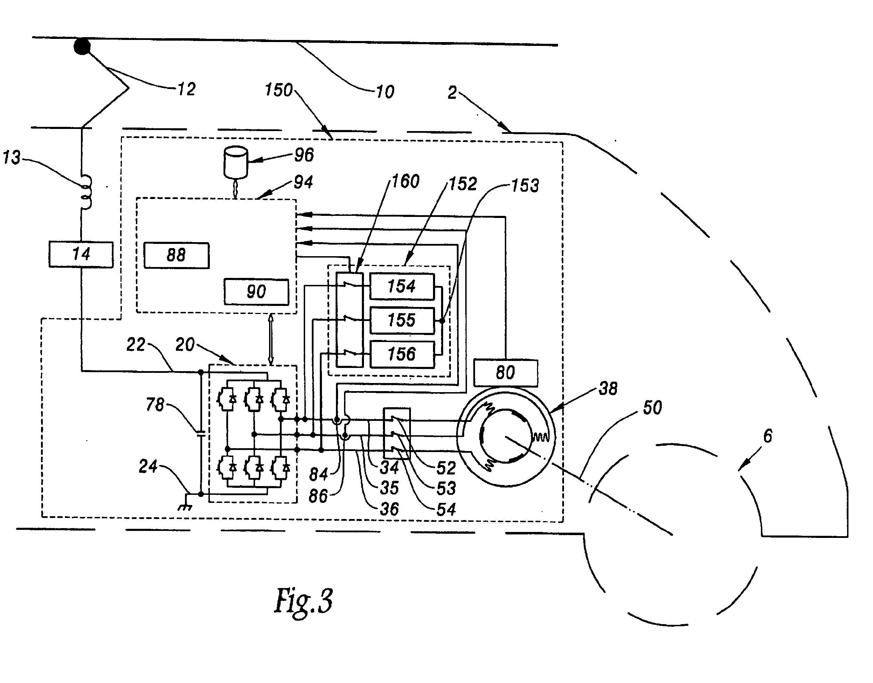

La figure 3 représente un autre mode de réalisation d'un système 150 de traction électrique du véhicule 2. Sur cette figure, les éléments déjà décrits en regard de la figure 1 portent les mêmes références numériques.

Le système 150 est identique au système 4 à l'exception du fait que la charge résistive 60 est remplacée par une charge résistive variable triphasée 152 raccordée entre les conducteurs de phase 34 à 36.

La charge 152 est formée de trois branches parallèles raccordées à l'une de leurs extrémités à un point commun 153. Les autres extrémités de ces branches sont raccordées respectivement aux conducteurs 34, 35 et 36. Chacune de ces branches comporte une résistance, respectivement 154 à 156, raccordée directement d'un côté au point commun 152 et de l'autre côté au conducteur de phase par l'intermédiaire d'un hacheur rhéostatique commandable 160. Le hacheur 160 est commandable par le module de diagnostic 90. La valeur des résistances 154 à 156 est constante.

La valeur des résistances 154 à 156 est choisie égale à $R_{int}$ de manière à ce que la valeur de la partie résistive de la charge 152 sur chacune des branches puisse varier entre $R_{int}$ et $2000.R_{int}$.

Le fonctionnement du système 150 se déduit de celui décrit en regard de la figure 2. En effet, comme dans le procédé de la figure 2, en cas de détection d'un défaut à partir des mesures du capteur 80, le module 90 ajuste la valeur de la partie résistive de la charge 152 pour qu'une partie substantielle du courant généré par le moteur 38 traverse le court-circuit résistif et qu'une autre partie substantielle circule dans les conducteurs de phase. Ainsi, comme dans le système 4, les capteurs de courant 84 et 86 peuvent être utilisés pour détecter l'existence d'un court-circuit résistif. Toutefois, dans ce mode de réalisation, le courant qui circule dans les conducteurs de phase ne traverse pas l'onduleur/redresseur 20 de sorte que dans ce mode de réalisation une défaillance de cet onduleur/redresseur 20 ne peut pas être détectée.

De nombreux autres modes de réalisation du système 4 ou du système 150 sont possibles. Par exemple, la partie résistive variable de la charge résistive peut être réalisée à partir d'une varistance dont la valeur varie en fonction de la tension appliquée entre ses bornes. La partie résistive variable peut également être réalisée en utilisant un convertisseur DC-DC.

Ici, dans le système 4, la partie résistive utilisée pour faire circuler une partie substantielle du courant dans les conducteurs de phase 34 à 36 est la même que celle utilisée lors d'un freinage rhéostatique pour dissiper l'énergie générée par le moteur 38. Toutefois, on remarquera que dans ces deux modes d'utilisation, la valeur de la partie résistive n'est pas ajustée de la même façon. En effet, en cas de freinage rhéostatique, la valeur de la résistance 62 est ajustée de manière à dissiper de façon adéquate l'énergie générée par le moteur 38 lors du freinage. Lorsque cette même résistance est utilisée pour mettre en oeuvre le procédé de dépistage, sa valeur est ajustée de manière à ce qu'une partie substantielle du courant triphasé généré par le moteur 38 circule dans les conducteurs de phase 34 à 36 pour qu'à partir de mesures de ce courant, le module 90 puisse détecter l'existence de ce court-circuit résistif.

En variante, en lieu et place de la résistance utilisée pour dissiper l'énergie lors du freinage du véhicule 2, une résistance d'écrêtage raccordée en parallèle entre les conducteurs 22 et 24 est utilisée lors de l'exécution du procédé de la figure 2. Lors du fonctionnement normal du système de traction, cette résistance d'écrêtage a pour fonction d'écrêter les surtensions qui peuvent apparaître entre les conducteurs 22 et 24.

Le système 2 a été décrit dans le cas particulier où le moteur 38 est un moteur à aimants permanents. Toutefois, le procédé de la figure 2 s'applique également à un système de traction dans lequel le moteur de traction est un moteur polyphasé synchrone bobiné, c'est-à-dire comportant des bobinages aussi bien au stator qu'au rotor.

Dans un mode de réalisation simplifié, la charge variable 60 et la charge variable 152 peuvent être remplacées par des charges dont la valeur de la partie résistive est constante. Dans ce mode de réalisation, la valeur de la partie résistive de cette charge est prédéterminée à l'avance par simulation ou expérimentalement pour que à une vitesse donnée du véhicule 2 elle permette dans la plupart des cas de courts-circuits résistifs à une partie substantielle du courant généré par le moteur de circuler dans les conducteurs de phase tandis qu'une autre partie substantielle traverse le court-circuit résistif.

En variante, une fois que la valeur de la partie résistive raccordée entre chaque paire de conducteurs de phase a été ajustée pour qu'une partie substantielle du courant généré par le moteur circule dans les conducteurs de phase, tandis qu'une autre partie substantielle traverse le court-circuit résistif, la présence du court-circuit résistif peut être détectée par d'autres méthodes que celle consistant à comparer la puissance des fondamentaux des courants mesurés.

Le procédé de dépistage décrit ici peut s'appliquer à des systèmes de traction autres que ceux mis en oeuvre dans un véhicule.

Dans un mode de réalisation simplifié, le capteur 80 peut être omis. Dans ce mode de réalisation simplifié, le procédé de dépistage d'un court-circuit résistif est, par exemple, déclenché au démarrage du système de traction. Le procédé de dépistage peut également être déclenché si un sur-courant est détecté à l'aide des capteurs 84 et 86.

## Revendications

1. Procédé de dépistage d'un court-circuit électrique impédant ayant une partie réelle non nulle, entre des enroulements de bobinages d'excitation d'un moteur polyphasé à aimants permanents ou d'un moteur polyphasé synchrone bobiné dans un système de traction électrique, le système de traction comportant :

   - le moteur polyphasé (38) à aimants permanents ou le moteur polyphasé synchrone bobiné, ce moteur ayant pour chaque phase un ou plusieurs bobinages d'excitation propre à générer un champ magnétique d'entraînement en rotation d'un arbre du moteur,
   - des conducteurs (34 à 36) de phase pour raccorder les bobinages de chaque phase du moteur à une source d'alimentation polyphasée commandable,
   - des capteurs (84, 86) de courant associés aux conducteurs de phase, ces capteurs étant propres à mesurer le courant circulant dans chaque conducteur de phase,
   - un module (88) de commande propre à commander le couple de l'arbre du moteur en fonction des courants mesurés par les capteurs, et
   - au moins une charge résistive (60 ; 152) raccordable entre chaque paire de conducteurs de phase par l'intermédiaire d'au moins un interrupteur commandable,

   **caractérisé en ce que** le procédé comporte les étapes consistant à :

   a) commander (en 122) le système de traction pour faire fonctionner le moteur en générateur de courant polyphasé,
   b) commander (en 124) le ou les interrupteurs commandables pour raccorder la charge résistive entre chaque paire de conducteurs de phase, cette charge résistive étant apte à permettre la détection d'un court-circuit électrique impédant ayant une partie réelle non nulle, au moins par comparaison des puissances des fondamentaux des courants mesurés par chacun des capteurs, et
   c) détecter (en 128, 138) l'existence du court-circuit électrique à partir des courants mesurés par les capteurs lorsque la charge résistive est raccordée entre chaque paire de conducteurs de phase et que le moteur fonctionne en générateur de courant.

2. Procédé selon la revendication 1, dans lequel le procédé comporte une étape d) de détection (en 110) d'une défaillance du système de traction sans qu'il soit nécessaire pour cela de faire fonctionner le moteur comme un générateur de courant, et dans lequel les étapes a) à c) sont déclenchées uniquement en réponse à la détection d'une défaillance lors de l'étape d).

3. Procédé selon l'une quelconque des revendications précédentes, pour un système de traction dans lequel la valeur de la partie résistive de la charge résistive est variable et dans lequel le procédé comporte une étape (136) d'ajustement de la valeur de cette partie résistive jusqu'à ce que la détection du court-circuit électrique soit au moins possible par comparaison des puissances des fondamentaux des courants mesurés par chacun des capteurs.

4.  Procédé selon la revendication 3, dans lequel la charge résistive raccordée entre chaque paire de conducteurs de phase lors de l'étape b), est la même que celle raccordée entre les conducteurs de phase pour dissiper l'énergie générée par le moteur lors d'un freinage de l'arbre du moteur.

5.  Procédé selon l'une quelconque des revendications précédentes, pour un système de traction dans lequel la source d'alimentation polyphasée comprend un onduleur/redresseur raccordé électriquement d'un côté aux conducteurs de phase et de l'autre à une paire de conducteurs de tension continue, et dans lequel l'étape b) consiste à commander le raccordement de la charge résistive entre les conducteurs de tension continue.

6.  Procédé selon l'une quelconque des revendications précédentes, pour un système dans lequel la résistance du ou des bobinages d'une même phase du moteur est appelée résistance interne et notée $R_{int}$, et dans lequel, lors de l'étape b), la valeur de la partie résistive de la charge raccordée entre chaque paire de conducteurs de phase est comprise entre $R_{int}$ et $200000.R_{int}$ de manière à ce qu'une partie du courant généré par le moteur traverse le court-circuit résistif tandis qu'une autre partie du courant généré par le moteur circule dans les conducteurs de phase.

7.  Support d'enregistrement d'informations, **caractérisé en ce qu'**il comporte des instructions pour l'exécution d'un procédé conforme à l'une quelconque des revendications précédentes, lorsque ces instructions sont exécutées par un calculateur électronique.

8.  Système de traction électrique, ce système comportant :

    - un moteur polyphasé (38) à aimants permanents ou un moteur polyphasé synchrone bobiné, ce moteur ayant pour chaque phase un ou plusieurs bobinages d'excitation propre à générer un champ magnétique d'entraînement en rotation d'un arbre du moteur,
    - des conducteurs (34 à 36) de phase pour raccorder les bobinages de chaque phase du moteur à une source d'alimentation polyphasée commandable,
    - des capteurs (84, 86) de courant associés aux conducteurs de phase, ces capteurs étant propres à mesurer le courant circulant dans chaque conducteur de phase,
    - un module (88) de commande propre à commander le couple de l'arbre du moteur en fonction des courants mesurés par les capteurs, et
    - au moins une charge résistive (60 ; 152) raccordable entre chaque paire de conducteurs de phase par l'intermédiaire d'au moins un interrupteur commandable,

    **caractérisé en ce que** ce système comporte également un module (90) de diagnostic apte à mettre en oeuvre un procédé de dépistage d'un court-circuit électrique impédant ayant une partie réelle non nulle, conforme à l'une quelconque des revendications 1 à 6.

9.  Module de diagnostic apte à être mis en oeuvre dans un système de traction conforme à la revendication 8, **caractérisé en ce que** ce module de diagnostic est apte à mettre en oeuvre le procédé de dépistage d'un court-circuit électrique impédant ayant une partie réelle non nulle, conforme à l'une quelconque des revendications 1 à 6.

**Claims**

1.  Method for tracing an impedant electrical short-circuit having a non-zero real part, between windings of coils for exciting a multiphase motor with permanent magnets or a coiled synchronous multiphase motor in an electrical traction system, the traction system comprising:

    - the multiphase motor (38) with permanent magnets or the coiled synchronous multiphase motor, this motor having for each phase one or more excitation coils capable of generating a magnetic field for driving in rotation a shaft of the motor,
    - phase conductors (34 to 36) for connecting the coils of each phase of the motor to a controllable multiphase power source,
    - current sensors (84, 86) associated with the phase conductors, these sensors being capable of measuring the current flowing in each phase conductor,

- a control module (88) capable of controlling the torque of the shaft of the motor as a function of the currents measured by the sensors, and
- at least one resistive load (60; 152) which can be connected between each pair of phase conductors via at least one controllable switch,

**characterised in that** the method includes the steps consisting in:

a) controlling (122) the traction system to cause the motor to operate in multiphase current-generating mode,
b) controlling (124) the controllable switch or switches for connecting the resistive load between each pair of phase conductors, this resistive load being capable of allowing detection of an impedant electrical short-circuit having a non-zero real part, at least by comparison of the powers of the fundamental components of the currents measured by each of the sensors, and
c) detecting (128, 138) the existence of the electrical short-circuit from the currents measured by the sensors when the resistive load is connected between each pair of phase conductors and the motor is operating in current-generating mode.

2. Method according to claim 1, wherein the method includes a step d) for detecting (110) a failure of the traction system without having to cause the motor to operate as a current generator and wherein steps a) to c) are triggered solely in response to the detection of a failure during step d).

3. Method according to either of the preceding claims, for a traction system wherein the value of the resistive part of the resistive load is variable and wherein the method includes a step (136) for adjusting the value of this resistive part until the detection of the electrical short-circuit can be at least performed by comparison of the powers of the fundamental components of the currents measured by each of the sensors.

4. Method according to claim 3, wherein the resistive load connected between each pair of phase conductors during step b) is the same as that connected between the phase conductors for dissipating the energy generated by the motor during braking of the motor shaft.

5. Method according to either of the preceding claims, for a traction system wherein the multiphase power source comprises an inverter/rectifier electrically connected, on the one side, to the phase conductors and, on the other side, to a pair of DC voltage conductors and wherein step b) consists in controlling the connection of the resistive load between the DC voltage conductors,

6. Method according to either of the preceding claims, for a system wherein the resistance of the coil or coils of a single phase of the motor is referred to as the internal resistance and denoted by Rint and wherein, during step b), the value of the resistive part of the load connected between each pair of phase conductors is between Rint and 200,000.Rint, so that one portion of the current generated by the motor passes through the resistive short-circuit whereas another portion of the current generated by the motor flows in the phase conductors.

7. Data recording medium, **characterized in that** it comprises operating instructions for the execution of a method according to either of claims 1 to 6, when these instructions are executed by a computer.

8. Electrical traction system, this system comprising:

- a multiphase motor (38) with permanent magnets or a coiled synchronous multiphase motor, this motor having for each phase one or more excitation coils capable of generating a magnetic field for driving in rotation a shaft of the motor,
- phase conductors (34 to 36) for connecting the coils of each phase of the motor to a controllable multiphase power source.
- current sensors (84, 86) associated with the phase conductors, these sensors being capable of measuring the current flowing in each phase conductor.
- a control module (88) capable of controlling the torque of the shaft of the motor as a function of the currents measured by the sensors, and
- at least one resistive load (60; 152) which can be connected between each pair of phase conductors via at least one controllable switch,

**characterized in that** this system also comprises a diagnostic module (90) capable of implementing the method for tracing an impedant electrical short-circuit having a non-zero real part, according to either of claims 1 to 6.

9. Diagnostic module capable of being implemented in an electrical traction system according to claim 8, **characterized in that** said diagnostic module is capable or implementing the method for tracing an impedant electrical short-circuit having a non-zero real part, according to either of claims 1 to 6.

**Patentansprüche**

1. Verfahren zur Erkennung eines impedanten elektrischen Widerstands mit einem realen Nichtnullanteil zwischen Erregerspulenwicklungen eines mehrphasigen Permanentmagneten-Motors oder eines gewickelten mehrphasigen Synchronmotors in einem elektrischen Antriebssystem, wobei das Antriebssystem umfasst:

   - den mehrphasigen Permanentmagneten-Motor (38) oder den gewickelten mehrphasigen Synchronmotor, wobei dieser Motor für jede Phase eine oder mehrere Erregerwicklungen hat, die ein Drehantriebmagnetfeld für eine Welle des Motors erzeugen,
   - Phasenstromleiter (34 bis 36), weiche die Wicklungen jeder Phase des Motors mit einer steuerbaren Mehrphasenversorgungsquelle verbinden,
   - Stromsensoren (84, 86), verbunden mit den Phasenstromleitern, wobei diese Sensoren fähig sind, den in jedem Phasenstromleiter fließenden Strom zu messen,
   - einen Steuermodul (88), fähig das Drehmoment der Motorwelle in Abhängigkeit von den durch die Sensoren gemessenen Strömen zu steuern, und
   - wenigstens eine zwischen jedem Phasenstromleiterpaar mittels eines steuerbaren Schalters anschließbare resistive Last (60; 125),

   **dadurch gekennzeichnet, dass** das Verfahren die folgenden Schritte umfasst:

   a) Steuern (in 122) des Antriebssystems derart, dass der Motor als mehrphasiger Stromgenerator arbeitet,
   b) Steuern (in 124) des/der steuerbaren Schalters/Schalter derart, dass die resistive Last zwischen jedem Phasenstromleiterpaar angeschlossen ist, wobei diese resistive Last fähig ist, zumindest durch Vergleichen der Leistungen der Grund- bzw. Fundamentalschwingungen *[fondamentaux]* der durch jeden der Sensoren gemessenen Ströme einen impedanten elektrischen Kurzschluss mit einem realen Nichtnullanteil zu detektieren, und
   c) Delektieren (in 128, 138) des elektrische Kurzschlusses aufgrund der durch die Sensoren gemessenen Ströme, wenn die resistive Last zwischen jedem Phasenstromleiterpaar angeschlossen ist und der Motor als Stromgenerator arbeitet.

2. Verfahren nach Anspruch 1, wobei das Verfahren einen Schritt d) zur Detektion (in 110) eines Ausfalls des Antriebssystems umfasst, ohne dass es notwendig ist, dazu den Motor als einen Stromgenerator arbeiten zu lassen, und bei dem die Schritte a) bis c) nur als Reaktion auf die Detektion eines Ausfalls während des Schrittes d) eingeleitet werden.

3. Verfahren nach einem der vorhergehenden Ansprüche für ein Antriebssystem, bei dem der Wert des resistiven Teils der resistiven Last variabel ist und bei dem das Verfahren einen Schritt (136) zur Anpassung des Werts dieses resistiven Teils umfasst, bis die Detektion des elektrischen Kurzschlusses zumindest durch Vergleich der Leistungen der Grund- bzw. Fundamentalschwingungen *[fondamentaux]* der durch jeden der Sensoren gemessenen Ströme möglich ist.

4. Verfahren nach Anspruch 3, bei dem die in Schritt b) zwischen jedem Phasenstromieiterpaar angeschlossene resistive Last dieselbe wie diejenige ist, die zwischen den Phasenstromleitern dazu dient, die durch den Motor bei einer Bremsung der Motorwelle erzeugte Energie in Wärme umzusetzen.

5. Verfahren nach einem der vorhergehenden Ansprüche für ein Antriebssystem, bei dem die Mehrphasenversorgungsquelle einen Wechselrichter/Gleichrichter umfasst, der elektrisch einerseits mit den Phasenstromleitern und andrerseits mit einem Gleichspannungsleiter paar verbunden ist, und bei dem der Schritt b) darin besteht, den Ahschluss der resistiven Last zwischen den Gleichspannungsleitern zu steuern.

6. Verfahren nach einem der vorhergehenden Ansprüche für ein System, bei dem der Widerstand der Wicklung oder Wicklungen einer selben Phase des Motors "interner Widerstand" genannt und mit $R_{int}$ bezeichnet wird, und bei dem während des Schritts b) der Wert des resistiven Teils der zwischen jedem Phasenstromleiterpaars angeschlos-

senen Last zwischen $R_{int}$ und 200000 $R_{int}$ enthalten ist, so dass ein Teil des durch den Motor erzeugten Stroms den resistiven Kurzschluss durchquert, während ein anderer Teil des durch den Motor erzeugten Stroms in die Phasenstromleiter fließt.

7. Informationsaufzeichnungsträger, **dadurch gekennzeichnet, dass** er Befehle zur Ausführung eines Verfahrens nach einem der vorhergehenden Anspruche umfasst, wenn diese Befehle durch einen elektronischen Rechner ausgeführt werden.

8. Elektrisches Antriebssystem, umfassend:

    - einen mehrphasigen Motor (38) mit Permanentmagneten oder einen gewickelten mehrphasigen Synchronmotor, wobei dieser Motor für jede Phase eine oder mehrere Erregerwicklungen zur Erzeugung eines Drehantriebmagnetfeldes für eine Welle des Motors umfasst,
    - Phasenstromleiter (34 bis 36), um die Wicklungen jeder Phase des Motors mit einer steuerbaren Mehrphasenversorgungsquelle zu verbinden,
    - Stromsensoren (84, 86), den Phaserstromleitern zugeordnet, wobei diese Sensoren fähig sind, den in jedem Phasenstromleiter fließenden Strom zu messen,
    - einen Steuerungsmodul (88), fähig das Drehmoment der Motorwelle in Abhängigkeit von den durch die Sensoren gemessenen Strömen zu steuern, und
    - wenigstens eine resistive Last (60; 152), anschließbar zwischen jedem Phasenstromleiterpaar mittels wenigstens eines steuerbaren Schalters,

    **dadurch gekennzeichnet, dass** das System auch einen Diagnosemodul (90) umfasst, fähig ein Verfahren zur Erkennung eines impedanten elektrischen Widerstands mit einem realen Nichtnullanteil gemäß einem der Ansprüche 1 bis 6 durchzuführen.

9. Diagnosemodul, fähig zu Anwendung in einem Antriebssystem gemäß Anspruch 8, **dadurch gekennzeichnet, dass** dieser Diagnosemodul das Erkennungsverfahren eines impedanten elektrischen Widerstands mit einem realen Nichtnullanteil durchführen kann, gemäß einem der Ansprüche 1 bis 6.

Fig.1

Fig.2

Fig.3

**RÉFÉRENCES CITÉES DANS LA DESCRIPTION**

**Documents brevets cités dans la description**

- WO 0106272 A
- US 6049185 A